# EUROPEAN PATENT APPLICATION

(11) **EP 4 776 313 A1**
(43) Date of publication of application: **15.07.2026**
(21) Application number: 25158269.8
(22) Date of filing: 17.02.2025
(51) Int. Cl.: H01G 4/224, H01G 4/228, H10D 1/60, H01G 2/06, H01G 4/33, H01G 4/38, H01L 23/48, H01L 23/522, H01L 23/64

(54) **DIE STACKED STRUCTURES AND PACKAGE STRUCTURES INCLUDING THE SAME**

(30) Priority: 14.01.2025 US 202519019466
(71) Applicant: Winbond Electronics Corp., Taichung City, Taiwan. (TW)
(72) Inventor: PARK, San-Ha, Taichung City (TW)
(74) Representative: Becker, Eberhard

(57) **Abstract**

A die stacked structure (99, 99A, 99B, 99C, 99D, 99E, 99F) includes a first die (100A, 100B, 100C, 100D, 100E, 100F), a second die (200A, 200B, 200C, 200D, 200E, 200F), a first connector (160a) and a second connector (160b). The first die (100A, 100B, 100C, 100D, 100E, 100F) includes a first interconnect structure (150) and a first capacitor (C1). The second die (200A, 200B, 200C, 200D, 200E, 200F) is bonded to the first die (100A, 100B, 100C, 100D, 100E, 100F). The second die (200A, 200B, 200C, 200D, 200E, 200F) includes a second interconnect structure (250) and a second capacitor (C2). The first connector (160a) and the second connector (160b) are connected to the first die (100A, 100B, 100C, 100D, 100E, 100F). The first capacitor (C1) is connected to the second capacitor (C2) through the first interconnect structure (150), bonding structures (260a, 260b) and the second interconnect structure (250).

## Description

### BACKGROUND

### Technical Field

Embodiments of the present disclosure are related to chip stacked structures and package structures having capacitors.

### Description of Related Art

System on chip (SOC) has the advantages of high speed and low power consumption. When the voltage applied by a power supply is lower, the SOC performance is more sensitive to the power supply noise. Therefore, such SOC needs a decoupling capacitor with larger capacitance and faster response characteristics. The decoupling capacitor has ultra-low equivalent series resistance/equivalent series inductance (ESR/ESL) characteristics.

### SUMMARY

The present disclosure provides a chip stacked structure which can increase the capacitance per unit area.

A chip stacked structure in an embodiment of the present disclosure includes a first chip, a second chip, a first connector and a second connector. The first chip includes a first interconnect structure, a first capacitor and a plurality of first through vias. The first capacitor is connected to the first interconnect structure, and the first interconnect structure is connected to the plurality of first through vias. The second chip is bonded to the first chip. The second chip includes a second interconnect structure and a second capacitor. The second capacitor is connected to the second interconnect structure. The first connector and the second connector are connected to the first chip. The first capacitor and the second capacitor are connected to each other through the first interconnect structure, a plurality of bonding structure and the second interconnect structure.

A package structure in an embodiment of the present disclosure includes the chip stacked structure, a third chip, a fourth chip, and an interposer or a substrate. The third chip is located on the fourth chip, and the fourth chip is located on the interposer or the substrate. The first connector and the second connector are connected to the third chip, the fourth chip, the interposer or the substrate.

A package structure in an embodiment of the present disclosure includes the chip stacked structure, a third chip, and an interposer or a substrate. The chip stacked structure is located between the third chip and the interposer, or between the third chip and the substrate. The first connector and the second connector are connected to the third chip.

Based on the above, in the chip stacked structure of the present disclosure, a single chip or each chip is configured to have through vias for connecting multiple capacitors in different chips, so that the capacitance per unit area of the stacked chips may be greatly increased. Therefore, the chip stacked structure of the present disclosure may be applied to high-frequency or low-power devices.

### BRIEF DESCRIPTION OF THE DRAWINGS

FIG. 1, FIG. 3, FIG. 4A, FIG. 5, FIG. 7, and FIG. 8 are schematic cross-sectional views of chip stacked structures according to various embodiments of the present disclosure.
FIG. 2 and FIG. 6 are circuit diagrams according to various embodiments of the present disclosure.
FIG. 4B and FIG. 4C are schematic cross-sectional views of hybrid bonding structures according to various embodiments of the present disclosure.
FIG. 9 to FIG. 12 are schematic cross-sectional views of package structures according to various embodiments of the present disclosure.

### DESCRIPTION OF THE EMBODIMENTS

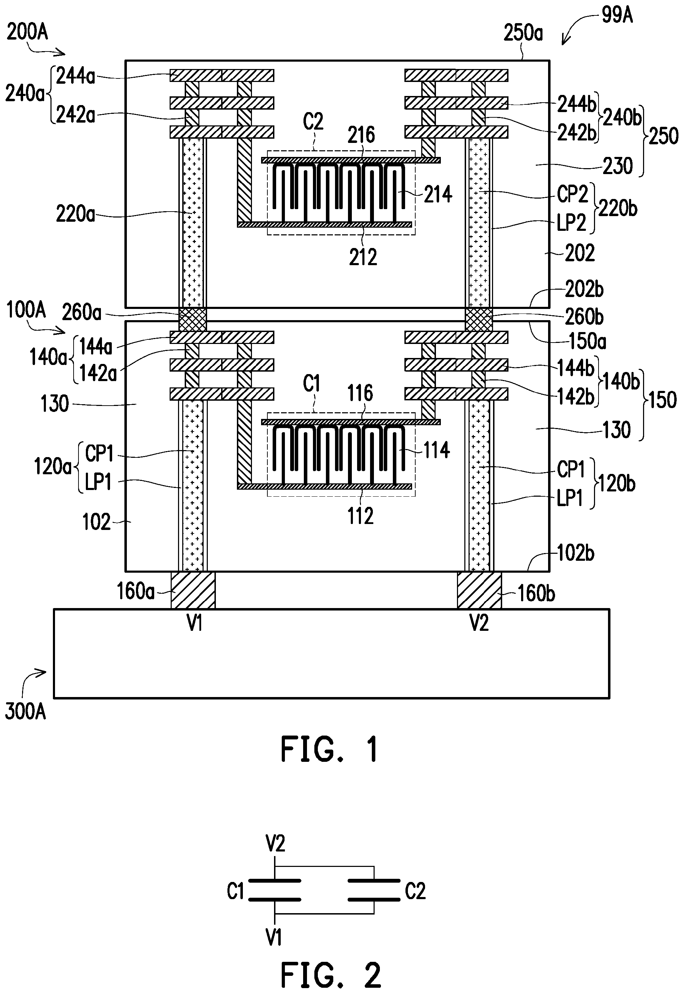

Referring to FIG. 1, a chip stacked structure 99A includes a first chip 100A, a second chip 200A, a first connector 160a and a second connector 160b. The first chip 100A is bonded to the second chip 200A, and each of the first chip 100A and the second chip 200A is an integrated circuit chip having a capacitor. The first chip 100A is further connected to or bonded to a third chip 300A through the first connector 160a and the second connector 160b.

The first chip 100A includes a first substrate 102, a first interconnect structure 150, a first capacitor C1, and multiple first through vias 120a, 120b. The first substrate 102 may include a semiconductor substrate or a semiconductor compound substrate, such as a silicon substrate or a silicon germanium substrate. At least one device (e.g., transistor) may further be included on or in the first substrate 102.

The first interconnect structure 150 is located over the first substrate 102. The first interconnect structure 150 may include a first dielectric layer 130 and first interconnect layers 140a and 140b. The first dielectric layer 130 may have a single-layer or multi-layer structure. The material of the first dielectric layer 130 may include silicon oxide, silicon oxynitride, a low dielectric constant material, or a combination thereof. The first interconnect layers 140a and 140b are disposed in the first dielectric layer 130, and are connected to the first capacitor C1 and/or connected to the device between the first substrate 102 and the first interconnect structure 150. The first interconnect layers 140a, 140b may include first conductive plugs 142a, 142b and first conductive layers 144a, 144b, respectively. The first conductive plugs 142a and 142b may be referred to as "contacts" or "vias" in some embodiments. The first conductive plugs 142a, 142b are respectively connected to the first conductive layers 144a, 144b, and are connected to the first capacitor C1, or/and further connected to the device between the first substrate 102 and the first interconnect structure 150. The first capacitor C1 is in contact with one of the first conductive plugs 142a and one of the first conductive plugs 142b.

The first through vias 120a, 120b extend from the bottom surface (or called "back side") 102b of the first substrate 102, penetrate through the entire first substrate 102, and extend continuously into the first dielectric layer 130. Each of the first through vias 120a, 120b may include a conductive pillar CP1 and a liner layer LP1 surrounding the sidewall of the conductive pillar CP1. The first through vias 120a, 120b may be respectively connected to the conductive layers 144a, 144b through the conductive pillars CP1. The first through vias 120a, 120b may be electrically insulated from the first substrate 102 by the liner layers LP1.

The first capacitor C1 may include a capacitor of dynamic random access memory, a metal-insulator-metal (MIM) capacitor or a trench capacitor, etc. The first capacitor C1 may be a first silicon capacitor with high capacitance and high response speed. The first capacitor C1 may be completely disposed in the first substrate 102. Alternatively, a part of the first capacitor C1 may be disposed in the first substrate 102, and another part of the first capacitor C1 may be disposed in the first dielectric layer 130.

The first capacitor C1 includes a first electrode plate 112, a second electrode plate 116, and a dielectric 114. The dielectric 114 is located between the first electrode plate 112 and the second electrode plate 116. The first electrode plate 112 is closer to the bottom surface 102b of the first substrate 102 than the second electrode plate 116. The first electrode plate 112 is connected to the first through via 120a through the conductive plugs 142a and the conductive layers 144a of the first interconnect layer 140a. The second electrode plate 116 is closer to the top surface 150a of the first interconnect structure 150 than the first electrode plate 112. The second electrode plate 116 is connected to the first through via 120b through the conductive plugs 142b and the conductive layers 144b of the first interconnect layer 140b.

Each of the first electrode plate 112 and the second electrode plate 116 includes a conductive material, such as titanium (Ti), titanium nitride (TiN), tantalum (Ta), tantalum nitride (TaN), aluminum (Al), aluminum titanium (AlTi), other suitable conductive material or a combination thereof. The dielectric 114 includes a high-k material (e.g., having a dielectric constant greater than about 3.9, or some other suitable value), such as zirconium oxide (ZrO₂), aluminum oxide (Al₂O₃), hafnium oxide (HfO₂), aluminum hafnium oxide (HfAlO), tantalum oxide (Ta₂O₅), other suitable dielectric material, or a combination thereof.

The second chip 200A may include a second substrate 202, a second interconnect structure 250, a second capacitor C2, and multiple second through vias 220a, 220b. The second substrate 202 may include a semiconductor substrate or a semiconductor compound substrate. The second substrate 202 may be the same as or different from the first substrate 102. Similarly, at least one active device (e.g., transistor) may further be included on or in the second substrate 202.

The second interconnect structure 250 is located over the second substrate 202. The second interconnect structure 250 may include a second dielectric layer 230 and second interconnect layers 240a and 240b. The second dielectric layer 230 may have a single-layer or multi-layer structure. The material of the second dielectric layer 230 may include silicon oxide, silicon oxynitride, a low dielectric constant material, or a combination thereof. The second interconnect layers 240a and 240b are disposed in the second dielectric layer 230, and are connected to the second capacitor C2, and/or connected to the device between the second substrate 202 and the second interconnect structure 250. The second interconnect layers 240a, 240b may include multiple second conductive plugs 242a, 242b and multiple second conductive layers 244a, 244b, respectively. The second conductive plugs 242a and 242b may be referred to as "contacts" or "vias" in some examples. The second conductive plugs 242a, 242b are respectively connected to the second conductive layers 244a, 244b, and are connected to the second capacitor C2 or/and the device between the second substrate 202 and the second interconnect structure 250.

The second through vias 220a, 220b extend from the bottom surface 202b of the second substrate 202, penetrate through the entire second substrate 202, and extend continuously into the second dielectric layer 230. Each of the second through vias 220a, 220b may include a conductive pillar CP2 and a liner layer LP2 surrounding the sidewall of the conductive pillar CP2. The second through vias 220a, 220b may be respectively connected to the conductive layers 244a, 244b through the conductive pillars CP2. The second through vias 220a, 220b may be electrically insulated from the second substrate 202 by the liner layers LP2.

The second capacitor C2 may include a capacitor of dynamic random access memory, a metal-insulator-metal (MIM) capacitor or a trench capacitor, etc. The second capacitor C2 may be a second silicon capacitor with high capacitance and high response speed. The second capacitor C2 may be completely disposed in the second substrate 202. Alternatively, a part of the second capacitor C2 may be disposed in the second substrate 202, and another part of the second capacitor C2 may be disposed in the second dielectric layer 230.

Referring to FIG. 1, the second capacitor C2 includes a first electrode plate 212, a second electrode plate 216, and a dielectric 214. The dielectric 214 is located between the first electrode plate 212 and the second electrode plate 216. The first electrode plate 212 is closer to the bottom surface 202b of the second substrate 202 than the second electrode plate 216. The first electrode plate 212 is connected to the second through via 220a through the conductive plugs 242a and the conductive layers 244a of the second interconnect layer 240a. The second electrode plate 216 is closer to the top surface 250a of the second interconnect structure 250 than the first electrode plate 212. The second electrode plate 216 is connected to the second through via 220b through the conductive plugs 242b and the conductive layers 244b of the second interconnect layer 240b. The materials of the first electrode plate 212, the second electrode plate 216 and the dielectric 214 may be the same or similar to those of the first electrode plate 112, the second electrode plate 116 and the dielectric 114.

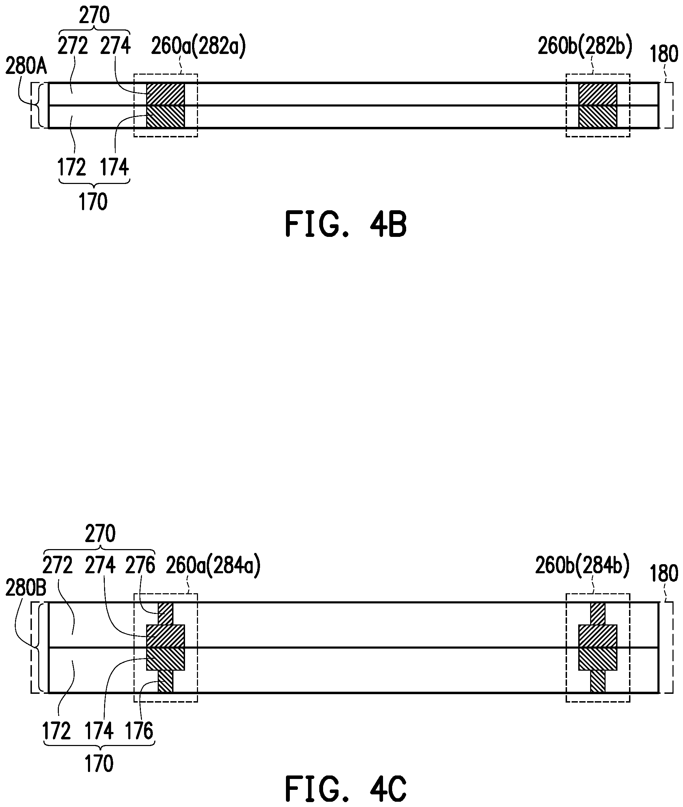

The first chip 100A and the second chip 200A may be bonded to each other through bonding structure 260a and 260b by using a wafer-on-wafer (WOW) process or a chip-on-wafer (COW) process. The bonding structures 260a and 260b may include multiple micro-bumps (as shown in FIG. 1) or bonding conductive structures 282a and 282b of a hybrid bonding structure 280A (as shown in FIG. 4B) or bonding conductive structures 284a and 284b of a hybrid bonding structure 280B (as shown in FIG. 4C).

Referring to FIG. 4B, the hybrid bonding structure 280A includes a first bonding structure 170 and a second bonding structure 270, which are respectively disposed on the first chip 100A and the second chip 200A and bonded to each other. The first bonding structure 170 includes a first bonding dielectric layer 172 and multiple first bonding pads 174. The first bonding pads 174 are provided in the first bonding dielectric layer 172. The second bonding structure 270 includes a second bonding dielectric layer 272 and multiple second bonding pads 274. The second bonding pads 274 are provided in the second bonding dielectric layer 272. The first bonding pads 174 and the second bonding pads 274 form bonding conductive structures 282a, 282b. The bonding conductive structure 282a is connected to the first interconnect layer 140a and the second interconnect layer 240a. The bonding conductive structure 282b is connected to the first interconnect layer 140b and the second interconnect layer 240b.

Referring to FIG. 4C, the hybrid bonding structure 280B is similar to the hybrid bonding structure 280A, but the first bonding structure 170 further includes first bonding plugs 176, and the second bonding structure 270 further includes second bonding plugs 276. The first bonding plugs 176 are provided in the first bonding dielectric layer 172 and connected to the first bonding pads 174. The second bonding plugs 276 are provided in the second bonding dielectric layer 272 and connected to the second bonding pads 274. The first bonding pads174, the first bonding plugs 176, the second bonding pads 274 and the second bonding plugs 276 form bonding conductive structures 284a, 284b. The bonding conductive structure 284a is connected to the first interconnect layer 140a and the second interconnect layer 240a. The bonding conductive structure 284b is connected to the first interconnect layer 140b and the second interconnect layer 240b.

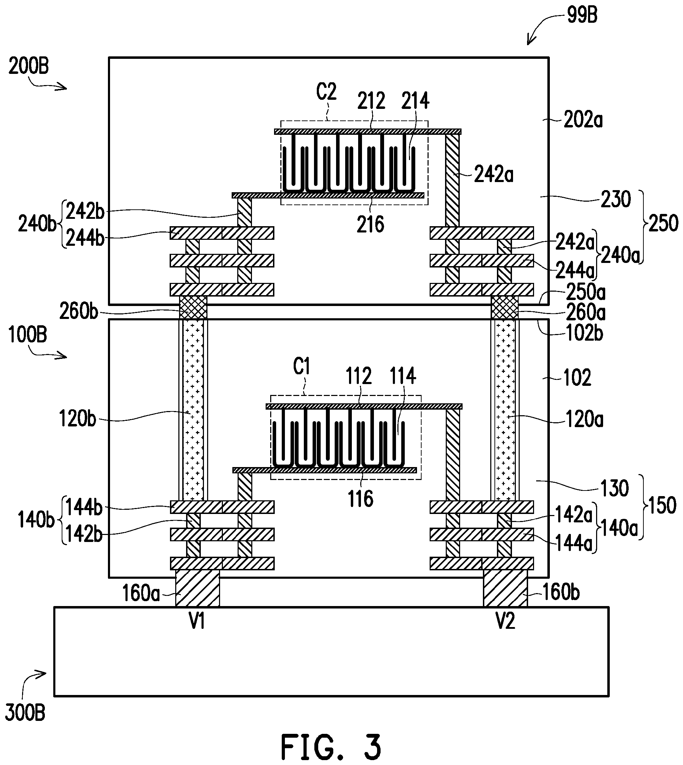

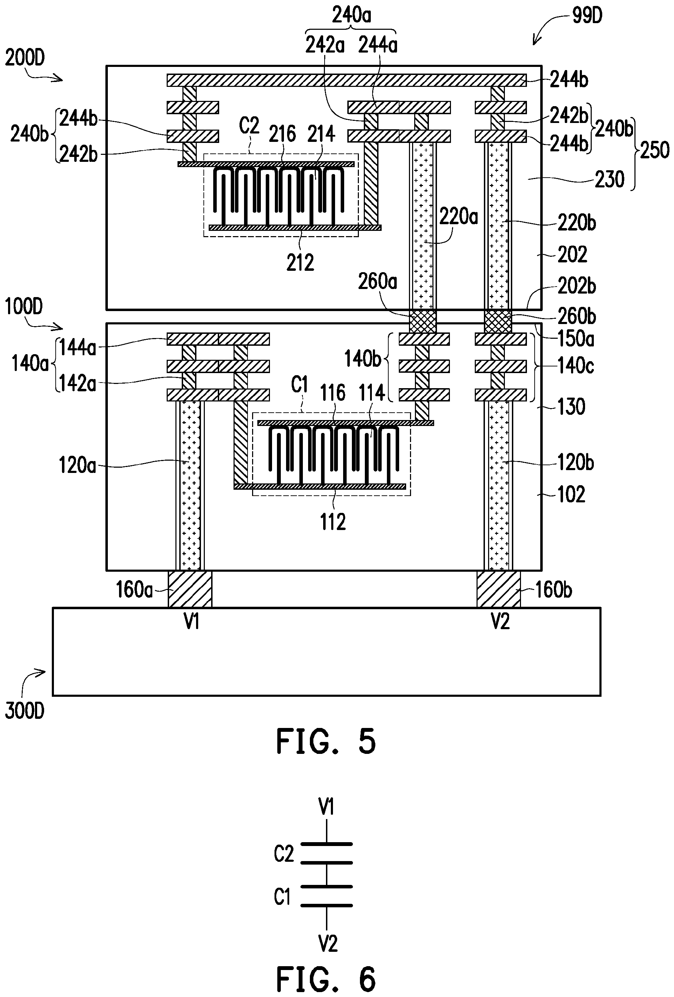

The first chip 100A and the second chip 200A may be bonded together in various methods, such as a face-to-back bonding, a face-to-face bonding, a back-to-face bonding, and so on. In addition, the second capacitor C2 may be connected in parallel or in series with the first capacitor C1, as shown in FIG. 3 and FIG. 6, respectively.

Referring to FIG. 1 and FIG. 3, in the chip stacked structure 99A of this embodiment, the first chip 100A and the second chip 200A are bonded through a face-to-back bonding. In other words, the top surface 150a of the first interconnect structure 150 on the front side of the first substrate 102 of the first chip 100A faces the bottom surface (or called "back side") 202b of the second substrate 202 of the second chip 200A.

Continue referring to FIG. 1, the second capacitor C2 and the first capacitor C1 of the chip stacked structure 99A of this embodiment are connected in parallel. The first electrode plate 112 of the first capacitor C1 is connected to the first electrode plate 212 of the second capacitor C2 through the first interconnect layer 140a, the bonding structure 260a, the second through via 220a and the second interconnect layer 240a, and is connected to the connector 160a through the first through via 120a and therefore connected to the third chip 300A. The second electrode plate 116 of the first capacitor C1 is connected to the second electrode plate 216 of the second capacitor C2 through the first interconnect layer 140b, the bonding structure 260b, the second through via 220b and the second interconnect layer 240b, and is connected to the connector 160b through the first through via 120b and therefore connected to the third chip 300A. The voltages V1 and V2 applied to the first capacitor C1 and/or the second capacitor C2 may be provided by the third chip 300A or another power supplier. The chip stacked structure 99A may be connected to or bonded to the first connector 160a and the second connector 160b by using a wafer-on-wafer (WOW) process or a chip-on-wafer (COW) process. The first connector 160a and the second connector 160b may be bumps or bonding conductive structures of hybrid bonding structures.

Referring to FIG. 1, in the chip stacked structure 99A, the first chip 100A is bonded to the second chip 200A through a face-to-back bonding, and the second capacitor C2 is connected in parallel with the first capacitor C1. However, the embodiments of the present disclosure are not limited thereto.

Referring to FIG. 5 and FIG. 6, in the chip stacked structure 99D, the first chip 100D is bonded to the second chip 200D through a face-to-back bonding, and the second capacitor C2 is connected in series with the first capacitor C1.

Referring to FIG. 1 and FIG. 5, the first chip 100D is similar to the first chip 100A, and the first interconnect structure of each of the first chips 100A and 100D is connected to the first capacitor C1 with similar connection relationship. The second chip 200D is similar to the second chip 200A, but the second interconnect layer structures of the second chips 200A and 200D are connected to the second capacitors C2 with different connection relationships.

Referring to FIG. 5, the first electrode plate 112 of the first capacitor C1 is connected to the first connector 160a through the first interconnect layer 140a, the first through via 120a and therefore connected to a third chip 300D. The second electrode plate 116 of the first capacitor C1 is connected to the first electrode plate 212 of the second capacitor C2 through the first interconnect layer 140b, the bonding structure 260a, the second through via 220a and the second interconnect layer 240a. The second electrode plate 216 of the second capacitor C2 is connected to the second connector 160b through the second interconnect layer 240b, the second through via 220b, the bonding structure 260b, the first interconnect layer 140c, and the first through via 120b and therefore connected to the third chip 300A.

Referring to FIG. 1 and FIG. 5, in the chip stacked structure 99A/99D, the first chip 100A/100D is bonded to the second chip 200A/200D through a face-to-back bonding. However, the embodiments of the present disclosure are not limited thereto.

Referring to FIG. 3 and FIG. 2, in the chip stacked structure 99B, the first chip 100B is bonded to the second chip 200B through a back-to-face bonding, and the second capacitor C2 is connected in parallel with the first capacitor C1.

Referring to FIG. 1 and FIG. 3, the first chip 100B is similar to the first chip 100A, and the first interconnect structure of each of the first chips 100A and 100B is connected to the first capacitor C1 with similar connection relationship. However, the bottom surface (or called "back side") 102b of the first chip 100B faces the second chip 200B.

Referring to FIG. 3, the second chip 200B is similar to the second chip 200A, and the second interconnect structure of each of the second chips 200A and 200B is connected to the second capacitor C2 with similar connection relationship. However, the front side 250a of the second chip 200B faces the first chip 100B.

Referring to FIG. 3, the first electrode plate 112 of the first capacitor C1 is connected to the first electrode plate 212 of the second capacitor C2 through the first interconnect layer 140a, the first through via 120a, the bonding structure 260a and the second interconnect layer 240a, and is connected to the first connector 160a through the first interconnect layer 140a and therefore connected to a third chip 300B. The second electrode plate 116 of the first capacitor C1 is connected to the second electrode plate 216 of the second capacitor C2 through the first interconnect layer 140b, the first through via 120b, the bonding structure 260b and the second interconnect layer 240b, and is connected to the connector 160b through the first interconnect layer 140b and therefore connected to the third chip 300B.

In this embodiment, the second capacitor C2 is connected to the first capacitor C1 through the second interconnect layers 240a, 240b, the bonding structures 260a, 260b and the first interconnect layers 140a, 140b, without second through vias. Therefore, the second chip 200B may not include second through vias.

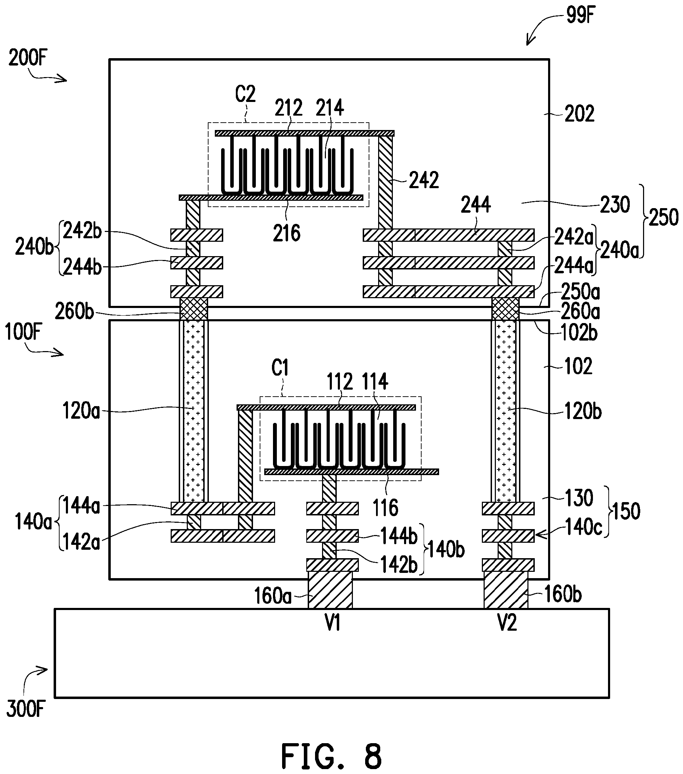

Referring to FIG. 8 and FIG. 6, in the chip stacked structure 99F, the first chip 100F is bonded to the second chip 200F through a back-to-face bonding, and the second capacitor C2 is connected in series with the first capacitor C1.

Referring to FIG. 8, the second chip 200F is similar to the second chip 200B, and the second interconnect layer structure of each of the second chips 200B and 200F is connected to the capacitor C2 with similar connection relationship. However, the first chip 100F is similar to the first chip 100B, but the first interconnect structures of the first chips 100B and 100F are slightly different.

Referring to FIG. 8, the first electrode plate 112 of the first capacitor C1 is connected to the second electrode plate 216 of the second capacitor C2 through the first interconnect layer 140a, the first through via 120a, the bonding structure 260b, and the second interconnect layer 240b.

Referring to FIG. 8, the second electrode plate 116 of the first capacitor C1 is connected to the first connector 160a through the first interconnect layer 140b and therefore connected to a third chip 300F. The first electrode plate 212 of the second capacitor C2 is connected to the second connector 160b through the second interconnect layer 240a, the bonding structure 260a, the first through via 120b and the first interconnect layer 140c and therefore connected to the third chip 300F.

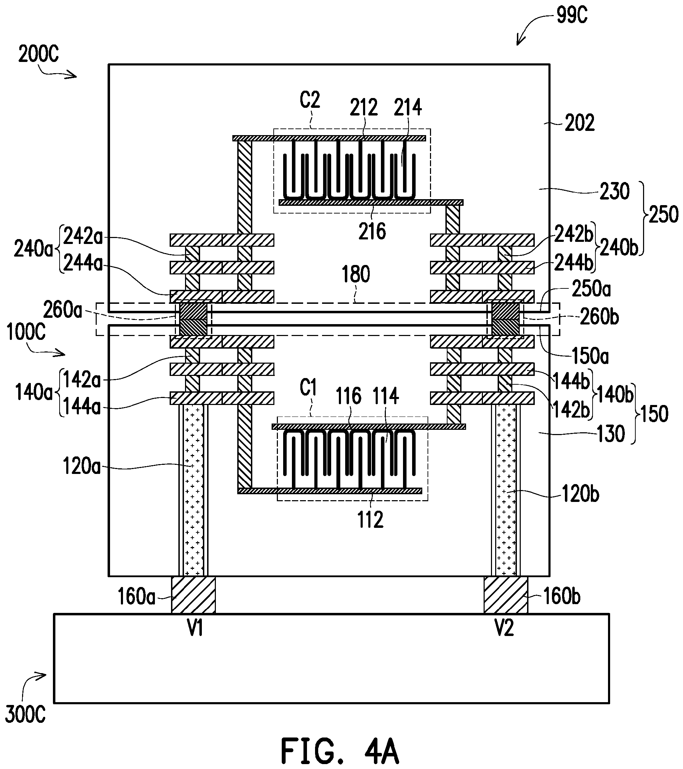

Referring to FIG. 1 and FIG. 4A, in the chip stacked structure 99C, the first chip 100C is bonded to the second chip 200C through a face-to-face bonding, and the second capacitor C2 is connected in parallel with the first capacitor C1. In FIG. 4A, the first chip 100C and the second chip 200C are bonded through a hybrid bonding, and the enlarged schematic views of the region 180 are shown in FIGS. 4B and 4C. However, the first bonding structures 260a and 260b of the first chip 100C and the second chip 200C may also be micro-bumps (as shown in FIG. 1).

Referring to FIG. 4A, the first chip 100C is similar to the first chip 100A, and the first interconnect structure of each of the first chips 100A and 100C is connected to the first capacitor C1 with similar connection relationship. The second chip 200C is similar to the second chip 200A, and the second interconnect structure of each of the second chips 200A and 200C is connected to the second capacitor C2 with similar connection relationship. However, the front side 250a of the second chip 200C faces the first chip 100C.

The first electrode plate 112 of the first capacitor C1 is connected to the first electrode plate 212 of the second capacitor C2 through the first interconnect layer 140a, the bonding structure 260a and the second interconnect layer 240a, and is connected to the connector 160a through the first interconnect layer 140a and the first through via 120a and therefore connected to a third chip 300C. The second electrode plate 116 of the first capacitor C1 is connected to the second electrode plate 216 of the second capacitor C2 through the first interconnect layer 140b, the bonding structure 260b, and the second interconnect layer 240b, and is connected to the connector 160b through the first interconnect layer 140b and the first through via 120b and therefore connected to the third chip 300C.

In this embodiment, the second capacitor C2 is connected to the first capacitor C1 through the second interconnect layers 240a, 240b, the bonding structure 260a, 260b and the first interconnect layers 140a, 140b, without second through vias. Therefore, the second chip 200C may not include second through vias.

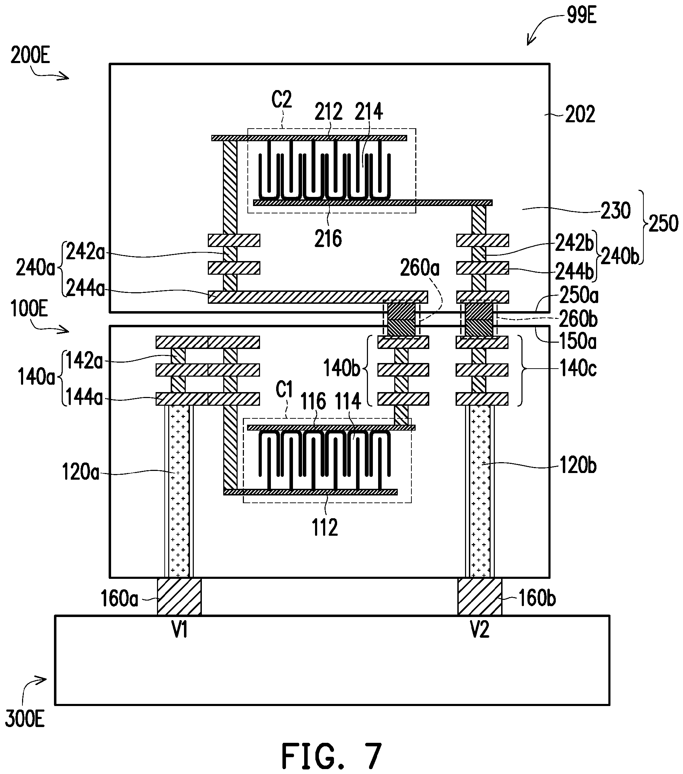

Referring to FIG. 7 and FIG. 6, the first chip 100E of the chip stacked structure 99E is bonded to the second chip 200E through a face-to-face bonding, and the second capacitor C2 is connected in series with the first capacitor C1.

The first chip 100E is similar to the first chip 100D, and the first interconnect structure of each of the first chips 100D and 100E is connected to the first capacitor C1 with similar connection relationship. The second chip 200E is similar to the second chip 200D, but the second interconnect structures of the second chips 200D and 200E are connected to the second capacitors C2 with different connection relationships.

The first electrode plate 112 of the first capacitor C1 is connected to the first connector 160a through the first interconnect layer 140a and the first through via 120a and therefore connected to a third chip 300E. The second electrode plate 116 of the first capacitor C1 is connected to the first electrode plate 212 of the second capacitor C2 through the first interconnect layer 140b, the bonding structure 260a, and the second interconnect layer 240a. The second electrode plate 216 of the second capacitor C2 is connected to the second connector 160b through the second interconnect layer 240b, the bonding structure 260b, the first interconnect layer 140c and the first through via 120b and therefore connected to the third chip 300E.

In this embodiment, the second capacitor C2 is connected to the first capacitor C1 through the second interconnect layers 240a, 240b, the bonding structure 260a, 260b and the first interconnect layers 140b, 140c, without second through vias. Therefore, the second chip 200E may not include second through vias.

The first chips 100A-100F of the present disclosure have first through vias 120a, 120b configured to be connected to the first capacitor C1 and the second capacitor C2. The second chips 200A, 200D of the present disclosure may have second through vias 220a, 220b configured to be connected to the first capacitor C1 and the second capacitor C2. The second chips 200B, 200C, 200E and 200F of the present disclosure may not include second through vias, because the connection between the second capacitor C2 and the first capacitor C1 does not need to pass through the second through vias.

Each of the chip stacked structures 99A-99F of the embodiment of the present disclosure is illustrated by two stacked chips, but the present disclosure is not limited thereto. In other embodiments, the chip stacked structure may include three or more stacked chips.

The chip stacked structures 99A-99F of the embodiments of the present disclosure may be applied to 2.5D or 3D package structures. For example, the chip stacked structures 99A-99F may be attached to the third chips 300A-300F through first connector 160a and second connector 160b, and the third chips 300A-300F may be further attached to a fourth chip, a substrate or an interposer. Alternatively, each of the chip stacked structures 99A-99F may be directly attached to a fourth chip, a substrate or an interposer. For the sake of brevity, each of the chip stacked structures 99A-99F is represented by a chip stacked structure 99, and each of the third chips 300A-300F is represented by a third chip 300 in the following embodiments.

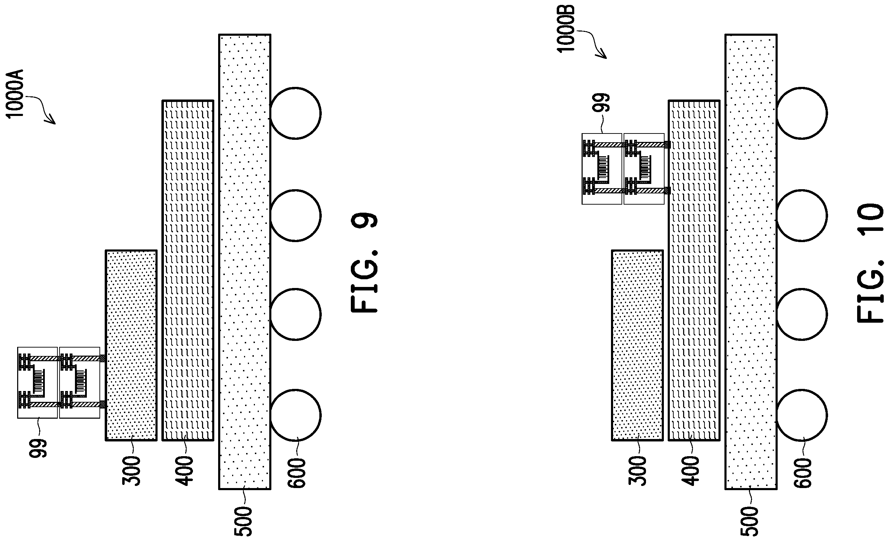

Referring to FIG. 9, a package structure 1000A includes a chip stacked structure 99, a third chip 300, a fourth chip 400, a substrate or an interposer 500 and multiple external connection terminals 600. The chip stacked structure 99 is attached to the third chip 300. The third chip 300 is attached to the fourth chip 400. The fourth chip 400 is attached to the substrate or the interposer 500. The substrate or the interposer 500 is connected to the multiple external connection terminals 600.

Referring to FIG. 10, a package structure 1000B is similar to the package structure 1000A, but the chip stacked structure 99 is attached to the fourth chip 400.

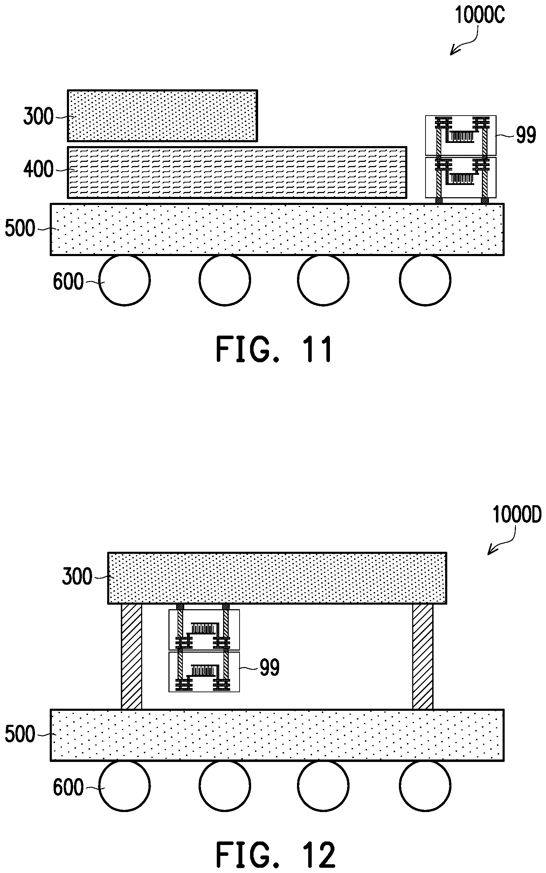

Referring to FIG. 11, a package structure 1000C is similar to the package structure 1000A, but the chip stacked structure 99 is attached to the substrate or the interposer 500.

Referring to FIG. 12, the chip stacked structure 99 of a package structure 1000D is attached to the third chip 300 and interposed between the third chip 300 and the substrate or the interposer 500.

In the above-mentioned package structures, the voltages applied to the capacitors may be supplied from the third chip 300 or the fourth chip 400, or supplied from the external connection terminals electrically connected to the third chip 300, the fourth chip 400 or the substrate or the interposer 500.

The chip stacked structure of the present disclosure can increase the capacitance per unit area of the stacked chips to 2 times, 3 times, 4 times or more according to the number of stacked chips. Moreover, the chip stacked structure of the present disclosure can further improve the time-dependent dielectric breakdown (TDDB) performance, increase the breakdown voltage (BV) and reduce the leakage current.

## Claims

1. A chip stacked structure (99, 99A, 99B, 99C, 99D, 99E, 99F), comprising:
a first chip (100A, 100B, 100C, 100D, 100E, 100F), comprising a first interconnect structure (150), a first capacitor (C1) and a plurality of first through vias (120a, 120b), wherein the first capacitor (C1) is connected to the first interconnect structure (150), and the first interconnect structure (150) is connected to the plurality of first through vias (120a, 120b);
a second chip (200A, 200B, 200C, 200D, 200E, 200F), bonded to the first chip (100A, 100B, 100C, 100D, 100E, 100F), and comprising a second interconnect structure (250), and a second capacitor (C2), wherein the second capacitor (C2) is connected to the second interconnect structure (250); and
a first connector (160a) and a second connector (160b), connected to the first chip (100A, 100B, 100C, 100D, 100E, 100F),
wherein the first capacitor (C1) and the second capacitor (C2) are connected to each other through the first interconnect structure (150), a plurality of bonding structures (260a, 260b) and the second interconnect structure (250).

2. The chip stacked structure of claim 1, wherein the first chip (100A, 100E) and the second chip (200A, 200E) are bonded through a face-to-back bonding, and the first connector (160a) and the second connector (160b) are respectively connected to the plurality of first through vias (120a, 120b) of the first chip (100A, 100E).

3. The chip stacked structure of claim 1, wherein the second chip (200A, 200E) further comprises:
a plurality of second through vias (220a, 220b), wherein the second capacitor (C2) is connected to the plurality of second through vias (220a, 220b) through the second interconnect structure (250).

4. The chip stacked structure of claim 3, wherein the first capacitor (C1) and the second capacitor (C2) are connected to each other further through the plurality of second through vias (220a, 220b).

5. The chip stacked structure of claim 4, wherein the first capacitor (C1) and the second capacitor (C2) are connected in parallel or in series.

6. The chip stacked structure of claim 4, wherein a first electrode plate (112) of the first capacitor (C1) and a first electrode plate (212) of the second capacitor (C2) are connected to the first connector (160a), and a second electrode plate (116) of the first capacitor (C1) and a second electrode plate (216) of the second capacitor (C2) are connected to the second connector (160b).

7. The chip stacked structure of claim 4, wherein a first electrode plate (112) of the first capacitor (C1) is connected to the first connector (160a), a second electrode plate (116) of the first capacitor (C1) is connected to a first electrode plate (212) of the second capacitor (C2), and a second electrode plate (216) of the second capacitor (C2) is connected to the second connector (160b).

8. The chip stacked structure of claim 1, wherein the first chip (100B, 100F) is bonded to the second chip (200B, 200F) through a back-to-face bonding, and the first connector (160a) and the second connector (160b) are connected to the first interconnect structure (150) of the first chip (100B, 100F).

9. The chip stacked structure of claim 1, wherein the first capacitor (C1) and the second capacitor (C2) are connected to each other further through the plurality of first through vias (120a, 120b).

10. The chip stacked structure of claim 9, wherein the first capacitor (C1) and the second capacitor (C2) are connected in parallel or in series.

11. The chip stacked structure of claim 9, wherein a second electrode plate (116) of the first capacitor (C1) and a second electrode plate (216) of the second capacitor (C2) are connected to the first connector (160a), and a first electrode plate (112) of the first capacitor (C1) and a first electrode plate (212) of the second capacitor (C2) are connected to the second connector (160b).

12. The chip stacked structure of claim 9, wherein a second electrode plate (116) of the first capacitor (C1) is connected to the first connector (160a), a first electrode plate (114) of the first capacitor (C1) is connected to a second electrode plate of the second capacitor, and a first electrode plate of the second capacitor is connected to the second connector.

13. The chip stacked structure of claim 1, wherein the first chip (100C, 100E) is bonded to the second chip (200C, 200E) through a face-to-face bonding, and the first connector (160a) and the second connector (160b) are connected to the plurality of first through vias (120a, 120b) of the first chip (100C, 100E).

14. The chip stacked structure of claim 13, wherein the first capacitor (C1) and the second capacitor (C2) are connected in parallel or in series.

15. The chip stacked structure of claim 13, wherein a first electrode plate (112) of the first capacitor (C1) and a first electrode plate (212) of the second capacitor (C2) are connected to the first connector (160a), and a second electrode plate (114) of the first capacitor (C1) and a second electrode plate (214) of the second capacitor (C2) are connected to the second connector (160b).

16. The chip stacked structure of claim 13, wherein a first electrode plate (112) of the first capacitor (C1) is connected to the first connector (160a), a second electrode plate (116) of the first capacitor (C1) is connected to a first electrode plate (212) of the second capacitor (C2), and a second electrode plate (216) of the second capacitor (C2) is connected to the second connector (160b).

17. The chip stacked structure of claim 1, wherein the plurality of bonding structure (260a, 260b) is a hybrid bonding structure or a plurality of micro-bumps.

18. The chip stacked structure of claim 1, wherein the first interconnect structure (150) comprises a plurality of first conductive plugs and a plurality of first conductive layers, wherein the plurality of first conductive plugs are respectively connected to the plurality of first conductive layers.

19. A package structure (1000A, 1000B, 1000C), comprising:
the chip stacked structure (99, 99A, 99B, 99C, 99D, 99E, 99F) of claim 1, a third chip (300), a fourth chip (400), and an interposer or a substrate (500), wherein the third chip (300) is located on the fourth chip (400), and the fourth chip (400) is located on the interposer or the substrate (500),
wherein the first connector and the second connector are connected to the third chip (300), the fourth chip (400), the interposer or the substrate (500).

20. A package structure (1000D), comprising:
the chip stacked structure (99, 99A, 99B, 99C, 99D, 99E, 99F) of claim 1, a third chip (300), and an interposer or a substrate (500), wherein the chip stacked structure is located between the third chip (300) and the interposer (500), or between the third chip (300) and the substrate (500),
wherein the first connector (160a) and the second connector (160b) are connected to the third chip (300).

## Amended claims

### Amended claims in accordance with Rule 137(2) EPC.

1. A chip stacked structure (99A, 99D), comprising:
a first chip (100A, 100D), comprising a first interconnect structure (150), a first capacitor (C1) and a plurality of first through vias (120a, 120b), wherein the first capacitor (C1) is connected to the first interconnect structure (150), the first interconnect structure (150) is connected to the plurality of first through vias (120a, 120b) and comprises a plurality of first conductive plugs (142a, 142b) and a plurality of first conductive layers (144a, 144b), and the plurality of first conductive plugs (142a, 142b) are respectively connected to the plurality of first conductive layers (144a, 144b);
a second chip (200A, 200D), bonded to the first chip (100A, 100D), and comprising a second interconnect structure (250), a second capacitor (C2) and a plurality of second through vias (220a, 220b), wherein the second capacitor (C2) is connected to the plurality of second through vias (220a, 220b) through the second interconnect structure (250); and
a first connector (160a) and a second connector (160b), connected to the first chip (100A, 100D),
wherein the first capacitor (C1) and the second capacitor (C2) are connected to each other through the first interconnect structure (150), a plurality of bonding structures (260a, 260b) and the second interconnect structure (250),
the chip stacked structure (99A, 99D) is **characterized in that**
the plurality of first conductive layers (144a, 144b) of the first chip (100A, 100D) and the plurality of second through vias (220a, 220b) of the second chip (200A, 200D) are directly connected to each other through the plurality of bonding structures (260a, 260b).

2. The chip stacked structure (99A, 99D) of claim 1, wherein the first chip (100A, 100D) and the second chip (200A, 200D) are bonded through a face-to-back bonding, and the first connector (160a) and the second connector (160b) are respectively connected to the plurality of first through vias (120a, 120b) of the first chip (100A, 100D).

3. The chip stacked structure (99A, 99D) of claim 1, wherein the first capacitor (C1) and the second capacitor (C2) are connected in parallel or in series.

4. The chip stacked structure (99A) of claim 1, wherein a first electrode plate (112) of the first capacitor (C1) and a first electrode plate (212) of the second capacitor (C2) are connected to the first connector (160a), and a second electrode plate (116) of the first capacitor (C1) and a second electrode plate (216) of the second capacitor (C2) are connected to the second connector (160b).

5. The chip stacked structure (99D) of claim 1, wherein a first electrode plate (112) of the first capacitor (C1) is connected to the first connector (160a), a second electrode plate (116) of the first capacitor (C1) is connected to a first electrode plate (212) of the second capacitor (C2), and a second electrode plate (216) of the second capacitor (C2) is connected to the second connector (160b).

6. A chip stacked structure (99B, 99F), comprising:
a first chip (100B, 100F), comprising a first interconnect structure (150), a first capacitor (C1) and a plurality of first through vias (120a, 120b), wherein the first capacitor (C1) is connected to the first interconnect structure (150), the first interconnect structure (150) is connected to the plurality of first through vias (120a, 120b);
a second chip (200B, 200F), bonded to the first chip (100B, 100F), and comprising a second interconnect structure (250) and a second capacitor (C2), wherein the second capacitor (C2) is connected to the second interconnect structure (250) and comprises a plurality of second conductive plugs (242a, 242b) and a plurality of second conductive layers (244a, 244b), and the plurality of second conductive plugs (242a, 242b) are respectively connected to the plurality of second conductive layers (244a, 244b); and
a first connector (160a) and a second connector (160b), connected to the first chip (100B, 100F),
wherein the first capacitor (C1) and the second capacitor (C2) are connected to each other through the first interconnect structure (150), a plurality of bonding structures (260a, 260b) and the second interconnect structure (250),
the chip stacked structure (99B, 99F) is **characterized in that**
the plurality of first through vias (120a, 120b) of the first chip (100B, 100F) and the plurality of second conductive layers (244a, 244b) of the second chip (200B, 200F) are directly connected to each other through the plurality of bonding structures (260a, 260b).

7. The chip stacked structure (99B, 99F) of claim 6, wherein the first chip (100B, 100F) is bonded to the second chip (200B, 200F) through a back-to-face bonding, and the first connector (160a) and the second connector (160b) are connected to the first interconnect structure (150) of the first chip (100B, 100F).

8. The chip stacked structure (99B, 99F) of claim 6, wherein the first capacitor (C1) and the second capacitor (C2) are connected in parallel or in series.

9. The chip stacked structure (99B) of claim 6, wherein a second electrode plate (116) of the first capacitor (C1) and a second electrode plate (216) of the second capacitor (C2) are connected to the first connector (160a), and a first electrode plate (112) of the first capacitor (C1) and a first electrode plate (212) of the second capacitor (C2) are connected to the second connector (160b).

10. The chip stacked structure (99F) of claim 6, wherein a second electrode plate (116) of the first capacitor (C1) is connected to the first connector (160a), a first electrode plate (112) of the first capacitor (C1) is connected to a second electrode plate (216) of the second capacitor (C2), and a first electrode plate (212) of the second capacitor (C2) is connected to the second connector (1600).

11. The chip stacked structure (99A, 99B, 99D, 99F) of claim 1 or claim 6, wherein the plurality of bonding structure (260a, 260b) is a hybrid bonding structure or a plurality of micro-bumps.

12. A package structure (1000A, 1000B, 1000C), comprising:
the chip stacked structure (99A, 99B, 99D, 99F) of claim 1 or claim 6, a third chip (300), a fourth chip (400), and an interposer or a substrate (500), wherein the third chip (300) is located on the fourth chip (400), and the fourth chip (400) is located on the interposer or the substrate (500),
wherein the first connector (160a) and the second connector (160b) are connected to the third chip (300), the fourth chip (400), the interposer or the substrate (500).

13. A package structure (1000D), comprising:
the chip stacked structure (99A, 99B, 99D, 99F) of claim 1 or claim 6, a third chip (300), and an interposer or a substrate (500), wherein the chip stacked structure (99A, 99B, 99D, 99F) is located between the third chip (300) and the interposer (500), or between the third chip (300) and the substrate (500),
wherein the first connector (160a) and the second connector (160b) are connected to the third chip (300).
